(19) Europäisches Patentamt
European Patent Office
Office européen des brevets

(11) **EP 2 123 420 B1**

(12) **EUROPÄISCHE PATENTSCHRIFT**

(45) Veröffentlichungstag und Bekanntmachung des Hinweises auf die Patenterteilung:
**01.05.2019 Patentblatt 2019/18**

(21) Anmeldenummer: **09159854.0**

(22) Anmeldetag: **11.05.2009**

(51) Int Cl.:
*B29C 44/12* (2006.01)     *B29C 70/66* (2006.01)
*B29C 70/68* (2006.01)     *B32B 5/20* (2006.01)
*B32B 17/10* (2006.01)     *B32B 37/20* (2006.01)
*B32B 27/30* (2006.01)     *B32B 27/40* (2006.01)
*B32B 3/08* (2006.01)      *B32B 27/22* (2006.01)
*B32B 27/20* (2006.01)     *B32B 25/20* (2006.01)
*B32B 25/18* (2006.01)     *B32B 25/14* (2006.01)
*B32B 25/04* (2006.01)     *B32B 7/12* (2006.01)
*B32B 27/08* (2006.01)     *B32B 27/06* (2006.01)
*B32B 27/18* (2006.01)     *B32B 38/00* (2006.01)
*B32B 27/32* (2006.01)     *H01L 33/56* (2010.01)
*B29L 31/34* (2006.01)     *B29K 105/04* (2006.01)

(54) **Verfahren zur Verkapselung von optoelektronischen Bauteilen**

Method for encapsulating optoelectronic components

Procédé d'encapsulage de composants optoélectroniques

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **21.05.2008   DE 102008024551**

(43) Veröffentlichungstag der Anmeldung:
**25.11.2009   Patentblatt 2009/48**

(73) Patentinhaber: **tesa SE**
**22848 Norderstedt (DE)**

(72) Erfinder:
• **Burmeister, Axel**
  **22527 Hamburg (DE)**
• **Czerwonatis, Franziska**
  **22393 Hamburg (DE)**

(56) Entgegenhaltungen:
DE-A1- 19 758 488      JP-A- 8 212 834
JP-A- 2002 043 598     JP-A- 2003 292 916
US-A1- 2002 166 687    US-A1- 2002 179 139
US-A1- 2005 133 085

**Beschreibung**

Die Erfindung betrifft ein Verfahren zur Verkapselung von optoelektronischen Bauteilen.

Der Begriff Optoelektronik (manchmal auch Optronik oder Optotronik genannt) entstand aus der Kombination von Optik und Mikroelektronik und umfasst im weitesten Sinne alle Produkte und Verfahren, die die Umwandlung von elektronisch erzeugten Daten und Energien in Lichtemission ermöglichen und umgekehrt. Hintergrund ist zum Beispiel der Versuch, die Vorteile der elektronischen Datenaufbereitung und Verarbeitung mit den Vorteilen der schnellen und elektromagnetisch und elektrostatisch unstörbaren breitbandigen Übertragungseigenschaft des Lichtes zu kombinieren. Gleichzeitig fällt hierunter auch die Wandlung von elektrischer Energie in Licht und umgekehrt auf der Basis der elektronischen Halbleitertechnik.

Optoelektronische Bauteile sind Bauteile, die als Schnittstelle zwischen elektrischen und optischen Komponenten wirken, oder auch Geräte, die solche Bauteile enthalten. Damit sind meist (aber nicht ausschließlich) mikroelektronische Bauteile gemeint, die auf der Basis von Halbleitern funktionieren. Optoelektronische Bauteile lassen sich bezüglich ihrer Funktion in Gruppen einteilen:

- Laserdiode

- Optoelektronische Aktoren
  Dazu gehören alle Halbleiterbauelemente, die aus Strom Licht erzeugen, also Laser- und Leuchtdioden.

- Optoelektronische Detektoren
  Dies sind die Umkehrbauelemente der Aktoren, also Fotowiderstand, Fotodiode (auch Solarzelle) und Fototransistor. Aber auch Fotomultiplier werden zur Optoelektronik gezählt.

Werden Aktor und Detektor als System betrieben, resultiert daraus ein optischer Sensor, ein so genannter Optosensor. Das Fachgebiet wird analog dazu als Optosensorik bezeichnet.

Der größte Bereich der optoelektronischen Bauteile sind so genannte Photovoltaik-Module.

Unter Photovoltaik versteht man die direkte Umwandlung von Strahlungsenergie, vornehmlich Sonnenenergie, in elektrische Energie mit Hilfe von Solarzellen.

Solarzellen gibt es in verschiedenen Ausführungsformen. Am weitesten verbreitet sind Dickschicht-Siliziumzellen entweder als monokristalline Zellen (c-Si) oder multikristalline Zellen (mc-Si). Vermehrt Verbreitung finden Dünnschichtzellen aus amorphem Silizium (a-Si), GaAs, CdTe, CIS-, CIGS sowie organische Solarzellen und Farbstoffzellen.

Solarzellen werden zur Energiegewinnung meist zu großen Solarmodulen verschaltet. Die Zellen werden dafür mit Leiterbahnen an Vorder- und Rückseite in Reihe geschaltet. Dadurch addiert sich die Spannung der Einzelzellen.

Die Fertigung eines Solarmoduls erfolgt weitestgehend mit der optisch aktiven Seite nach unten. Als erstes wird ein entsprechendes Glas, normalerweise handelt es sich um eisenarmes, gehärtetes Weißglas in 3 bis 4 mm Stärke mit möglichst geringer Absorption zwischen 350 bis 1150 nm, gereinigt und bereitgelegt. Auf dieses kommt dann eine zugeschnittene Bahn EVA-Folie. Die Solarzellen werden mittels Lötbändchen zu einzelnen Strängen (so genannte Strings) verbunden und auf der Scheibe mit der EVA-Folie positioniert. Nun werden die Querverbinder, die die einzelnen Stränge miteinander verbinden und zum Ort der Anschlussdose führen, positioniert und verlötet. Anschließend wird alles nacheinander mit einer zugeschnittenen EVA-Folie und einer Tedlar-(Polyvinylfluorid-)folie bedeckt. Als nächster Produktionsschritt erfolgt das Laminieren des Moduls bei einem Unterdruck und ca. 150 °C. Beim Laminieren bildet sich aus der bis dahin milchigen EVA-Folie eine klare, dreidimensional vernetzte und nicht mehr aufschmelzbare Kunststoffschicht, in der die Zellen nun eingebettet sind und die fest mit der Glasscheibe und der Rückseitenfolie verbunden ist. Nach dem Laminieren werden die Kanten gesäumt, und die Anschlussdose wird gesetzt. Nun wird das Modul noch gerahmt, vermessen und nach seinen elektrischen Werten klassifiziert und verpackt.

Der Vorgang des Laminierens ist sehr zeit- und energieaufwändig, es werden in der Regel Temperaturen von 150 °C für 10 bis 20 min aufgewendet. Versuche, das Laminieren deutlich zu beschleunigen, konnten sich bislang am Markt nicht durchsetzen.

In der WO 94/22172 A1 wird ein Rollenlaminator anstelle des üblichen Plattenlaminators vorgeschlagen.

In der JP 09 312 410 A1 wird die Verwendung eines thermoplastischen Polyurethans beschrieben. Die EP 1 302 988 A1 beschreibt ein Verfahren zur Verkapselung und Verdrahtung von Solarzellen zwischen zwei Substraten, welche eine geringe Wasserdampfdurchlässigkeit aufweisen, durch ein aliphatisches thermoplastisches Polyurethan.

Allen in den genannten Schriften offenbarten Verfahren ist zu eigen, dass die zum Teil 200 bis 400 $\mu$m dicken verdrahteten Solarzellen erst langsam umschlossen werden müssen, um eine sichere Verkapselung zu gewährleisten.

In der US 2002/0166687 A1 wird ein elektrisches Bauteil, das sich beispielsweis auf einer Platine befindet, von einem Polymer, das Mikroballons enthält, vollständig umschlossen. Das aufgeschäumte Polymer ist nicht lichtdurchlässig.

In der JP 2002 043598 A wird eine Versiegelungsfolie für eine Solarbatterie offenbart, die eine schäumbare Klebeharzzusammensetzung umfasst, die durch Erwärmen schäumt. Die Solarbatterie umfasst eine Zelle für die Batterie, die unter Verwendung der Versiegelungsfolie zwischen einer Vorderseitenplatte und einer Rückabdeckung versiegelt ist, so dass die Versiegelungsfolie für die Batterie als eine Vorderseiten-Versiegelungsfolie und / oder eine Rückseiten-Versiegelungsfolie verwendet wird.

Optoelektronische Komponenten müssen häufig vor dem Eintritt von Wasserdampf und Sauerstoff sowie mechanisch geschützt werden, um eine Degradation der Komponenten selbst oder deren Kontaktierung zu verhindern oder zu unterdrücken.

Aufgabe der Erfindung ist es, ein sicheres und schnelles Verfahren zur Verkapselung von optoelektronischen Bauteile zur Verfügung zu stellen, welches mit etablierten Verfahren und Rohstoffen ohne risikoreiche und kostenintensive Investition umsetzbar ist.

Gelöst wird diese Aufgabe durch ein Verfahren, wie es im Hauptanspruch näher gekennzeichnet ist. In den Unteransprüchen sind vorteilhafte Ausführungsformen der Erfindung beschrieben.

Demgemäß betrifft die Erfindung ein Verfahren zur Verkapselung von optoelektronischen Bauteilen, wobei die zu verkapselnden Bauteile zwischen einer ersten transparenten Polymerschicht und einer zweiten Polymerschicht, welche mit nicht aktiviertem Schäumungsmittel gefüllt ist, eingebettet werden und anschließend das Schäumungsmittel aktiviert wird, so dass sich die beiden Polymerschichten miteinander verbinden, insbesondere miteinander verschweißen und die Bauteile zwischen beiden Polymerschichten eingeschlossen sind, dadurch gekennzeichnet, dass es sich bei dem Schäumungsmittel um Mikrokugeln, die aus einer Polymermembran bestehen, die ein Treibmittel umschließt, handelt.

Unter dem Begriff "verschweißen" wird erfindungsgemäß verstanden, dass die Polymerschichten untrennbar miteinander verbunden sind oder dass sie zumindest nur irreversibel unter Zerstörung des entstandenen Aufbaus getrennt werden können.

Selbstverständlich wählt der Fachmann die Lage der Bauteile derart, dass sich die optisch aktive Seite der Bauteile unterhalb der transparenten Polymerschicht befindet.

Die transparente Polymerschicht weist vorzugsweise eine Transmission von größer 60 %, insbesondere eine Transmission größer 90 % bei einer Wellenlänge von 350 bis 1150 nm auf.

Mit dem Transmissionsgrad - bisweilen auch nur kurz als Transmission bezeichnet -, der in der Regel in % angegeben wird, ist das Verhältnis der auf der Rückseite eines mit Licht durchstrahlten Körpers ankommenden Lichtleistung zu der auf der Vorderseite eintreffenden Lichtleistung gemeint. Die Transmission wird beschnitten durch Reflektion und Absorption.

Es gilt also:

$$\text{Transmissionsgrad} = (1 - \text{Reflektionsgrad}) \times (1 - \text{Absorptionsgrad}).$$

Die Polymerschicht(en) können entweder als hitzeaktivierbare Schicht, unter Andruck leicht haftende Schicht oder unter Druck und ohne Temperatur stark klebende Schicht vorliegen.

Für die erste transparente Polymerschicht eignen sich als Ausgangsstoffe dieselben Polymere wie für die zweite mit nicht expandierten expandierbaren Mikroballons abgemischte Polymerschicht.

Neben den klassischen Polymeren wie EVA (zum Beispiel Elvax® von DuPont), Ethylen/Methacrylsäure (zum Beispiel Surlyn® von Dupont), TPU (Desmopan® von Bayer) und PVB (zum Beispiel Butacite® von DuPont) sind auch Acrylate, Silikonkautschuke, PIB und Styrolblockcopolymere verwendbar.

In einer weiteren Ausführungsform der Erfindung stellen die Polymerschicht(en) eine Klebemasse auf Polyethylenvinylacetat-Basis (EVA) mit einem Vinylacetatanteil von 10 bis 90 Gew.-% und mit einem Schmelzindex MFI nach ISO 1133 (A/4) von 0,5 bis 25 g/10 min bei 190 °C und 2,16 kg dar.

Neben EVA basierenden Systemen sind auch PIB und SBC basierende Systeme hervorragend geeignet, weil sie neben einer sehr hohen Verklebungsfestigkeit auch eine sehr geringe Wasserdampfdurchlässigkeit aufweisen.

In einer besonderen Ausführungsform basiert die Klebmasse auf Polyisobutylen als Basispolymer. Um der Klebmasse die erforderliche Anfassklebrigkeit zu verleihen, wird sie mit Harzen gemischt. Als Elastomer wird eine Mischung eines mittelmolekularen mit einem höher molekularen Polyisobutylen verwendet. Als bislang scherfesteste Ausführung hat es sich erwiesen, als mittelmolekulare Polyisobutylenkomponente eine Type mit einem mittleren Molekulargewicht $M_W$ von 40.000 zu nehmen, welches unter der Typenbezeichnung "Oppanol B10" von der Firma BASF SE im Handel frei erhältlich ist, und als hochmolekulare Polyisobutylenkomponente eine Type mit einem mittleren Molekulargewicht $M_W$ von 2.600.000 zu nehmen, welches unter der Typenbezeichnung "Oppanol B150" ebenfalls frei erhältlich ist.

Als Klebemassen, bevorzugt Haftklebemassen, für die Polymerschicht(en) finden des Weiteren solche auf Basis von Blockcopolymeren enthaltenden Polymerblöcke gebildet von Vinylaromaten (A-Blöcke) wie zum Beispiel Styrol und solchen gebildet durch Polymerisation von 1,3-Dienen (B-Blöcke) wie zum Beispiel Butadien und Isopren oder einem Copolymer aus beidem Anwendung. Es können auch Mischungen unterschiedlicher Blockcopolymere zum Einsatz kommen. Auch Produkte, die zum Teil oder vollständig hydriert sind, können eingesetzt werden.

Die Blockcopolymere können lineare A-B-A-Struktur aufweisen. Einsetzbar sind ebenfalls Blockcopolymere von radialer Gestalt sowie sternförmige und lineare Multiblockcopolymere. Als weitere Komponente werden A-B-Zweiblockcopolymere eingesetzt, wobei der Anteil an Zweiblockcopolymeren am gesamten Elastomergehalt mindestens 50 % beträgt. Vorzugsweise werden solche Blockcopolymere eingesetzt, die einen Polystyrolgehalt von über 20 Gew.-% besitzen.

Typische Einsatzkonzentrationen für das Blockcopolymer liegen in einer Konzentration im Bereich zwischen 30 Gew.-% und 70 Gew.-%, insbesondere im Bereich zwischen 35 Gew.-% und 55 Gew.-%.

Die Klebemasse der Polymerschicht(en) kann durch chemische, insbesondere strahlenchemische, zum Beispiel durch UV-Bestrahlung, oder durch Bestrahlung mittels schneller Elektronen, vernetzt werden.

Die Klebmasse kann zur Erzielung ergänzender gewünschter Eigenschaften abgemischt sein mit einem oder mehreren Additiven wie Klebharzen, Weichmachern, Alterungsschutzmitteln oder Füllstoffen.

Klebharze zur Steigerung der adhäsiven Eigenschaften des Klebers sind beispielsweise Kohlenwasserstoffharze (zum Beispiel aus ungesättigten $C_5$- und/oder $C_9$-Monomeren), hydrierte Polymerisate des Dicyclopentadiens, Terpenphenolharze, Terpenharze aus Rohstoffen wie $\alpha$- oder $\beta$-Pinen, aromatische Harze wie Cumaron-Inden-Harze oder Harze aus Styrol oder $\alpha$-Methylstyrol, bevorzugt nicht hydrierte, partiell oder vollständig hydrierte Harze auf Basis von Kolophonium und seinen Folgeprodukten wie disproportionierte, dimerisierte oder veresterte Harze, wobei Glycole, Glycerin oder Pentaerythrit zur Veresterung eingesetzt werden können, sowie weitere wie aufgeführt in Ullmann's Enzyklopädie der technischen Chemie, Band 12, Seiten 525 bis 555 (4. Auflage), Weinheim. Besonders geeignet sind alterungsstabile Harze ohne olefinische Doppelbindung wie zum Beispiel hydrierte Harze. Besonders bevorzugt werden Polyterpenharze auf Basis von $\alpha$-Pinen und/oder $\beta$-Pinen und/oder $\delta$-Limonen verwendet. Vorgenannte Klebharze können sowohl allein als auch im Gemisch eingesetzt werden.

Optional zu verwendende Weichmacher sind beispielsweise aliphatische, cycloaliphatische und aromatische Mineralöle, Di- oder Poly-Ester der Phthalsäure, Trimellitsäure oder Adipinsäure, Polyether sowie flüssige Kautschuke (zum Beispiel Nitril- oder Polyisoprenkautschuke), flüssige Polymerisate aus Buten und/oder Isobuten, Acrylsäureester, Polyvinylether, Flüssig- und Weichharze auf Basis der Rohstoffe zu Klebharze, Wollwachs und andere Wachse oder flüssige Silikone.

Um die Klebmasse noch beständiger gegen UV-Einfluss zu machen, ist der Zusatz von Lichtschutzmitteln möglich. Ihre Funktion besteht vorrangig in der Vermeidung der Zersetzung der Klebmasse. Insbesondere HALS-Lichtschutzmittel wie zum Beispiel Dimethylsuccinat-Polymer mit 4-Hydroxy-2,2,6,6-tetramethyl-1-piperidinethanol (CAS-Nr. 65447-77-0), Bis(2,2,6,6-tetramethyl-4-piperidinyl)sebacat (CAS-Nr. 52829-07-9) oder Poly[[6-[(1,1,3,3-tetramethyl butyl) amino]-1,3,5-triazine-2,4-diyl][[(2,2,6,6-tetramethyl-4-piperidyl) imino] hexamethylene [(2,2,6,6-tetramethyl-4-piperidyl) imino]] (CAS-Nr. 70624-18-9) sind für die Klebmasse geeignet.

Als weitere Additive können typischerweise genutzt werden:

- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Endblockverstärkerharze sowie
- gegebenenfalls weitere Polymere von bevorzugt elastomerer Natur; entsprechend nutzbare Elastomere beinhalten unter anderem solche auf Basis reiner Kohlenwasserstoffe, zum Beispiel ungesättigte Polydiene wie natürliches oder synthetisch erzeugtes Polyisopren oder Polybutadien, chemisch im wesentlichen gesättigte Elastomere wie zum Beispiel gesättigte Ethylen-Propylen-Copolymere, $\alpha$-Olefincopolymere, Polyisobutylen, Butylkautschuk, Ethylen-Propylenkautschuk sowie chemisch funktionalisierte Kohlenwasserstoffe wie zum Beispiel halogenhaltige, acrylathaltige oder vinyletherhaltige Polyolefine, um nur einige wenige zu nennen.

In einer weiteren bevorzugten Ausführungsform bestehen die Polymerschicht(en) aus einem Acrylat, diese zeichnen sich durch hohe Alterungsstabilität, sehr hohe Verklebungswerte und geringe Absorption aus.

Vorzugsweise basiert die Klebemasse auf Acrylat- oder Polyethylenvinylacetatpolymeren.

Acrylatdispersionen sind bekannt und werden sowohl für Klebemassen von Klebebändern als auch für Klebemassen von Etiketten in großen Mengen eingesetzt. Die Acrylatdispersionen enthalten Partikel aus Acrylatpolymeren, die dispers in der wässrigen Phase der Dispersion verteilt sind. Die Herstellung von Acrylatdispersionen erfolgt üblicherweise in wässrigem Medium durch Polymerisation geeigneter Monomere. Die Herstellung kann sowohl mittels Batchprozess als auch durch Zudosierung einer oder mehrerer Komponenten während der Polymerisation erfolgen. Beim Batchprozess werden alle benötigten Komponenten gleichzeitig vorgelegt.

Die Eigenschaften der Acrylatdispersionen und der entsprechenden Klebemassen wird überwiegend durch die Auswahl der Monomere und das erzielte Molekulargewicht bestimmt. Die wichtigsten Monomere sind n-Butylacrylat, 2-Ethylhexylacrylat und Acrylsäure. Geeignete Monomerbausteine sind beschrieben in "Acrylic Adhesives", Donatas Satas in Handbook of Pressure Sensitive Adhesive Technology, Second Edition, edited by Donatas Satas, Van Nostrand Reinhold New York, Seiten 396 bis 456.

Verwendete Acrylatdispersionen enthalten insbesondere [jeweils Gew.-%]

0 bis 10 % Acrylsäure-Einheiten
0 bis 100 % n-Butylacrylat-Einheiten
0 bis 100 % 2-Ethylhexylacrylat-Einheiten.

In einer bevorzugten Ausführung werden Acrylatdispersionen mit 0,5 bis 3 Gew.-% Acrylsäure-Einheiten verwendet. In einer weiteren bevorzugten Ausführung werden Acrylatdispersionen mit 0,5 bis 3 Gew.-% Acrylsäure-Einheiten und 99,5 bis 90 Gew.-%, besonders bevorzugt 99,5 bis 96 Gew.-%, n-Butylacrylat-Einheiten verwendet. Ein weiteres Beispiel für erfindungsgemäße Acrylatdispersionen sind Acrylatdispersionen mit 80 bis 90 Gew.-% 2-Ethylhexylacrylat-Einheiten und 8 bis 20 Gew.-% n-Butylacrylat-Einheiten.

Die Acrylatdispersionen können zusätzlich weitere Monomer-Einheiten enthalten, durch die beispielsweise die Glasübergangstemperatur und die Vernetzbarkeit gesteuert werden kann. Beispiele sind Methylacrylat, Ethylacrylat, Methylethylacrylat, Maleinsäureanhydrid, Acrylamid, Glycidylmethacrylat, Isopropylacrylat, n-Propylacrylat, Isobutylacrylat, n-Octylacrylat sowie die entsprechenden Methacrylate dieser Acrylate. Die Acrylatdispersionen enthalten üblicherweise 0 bis 10 Gew.-% dieser zusätzlichen Monomereinheiten, entweder werden ausschließlich eine zusätzliche Monomereinheit oder Mischungen derselben verwendet.

Die erzielte Glasübergangstemperatur hängt von den eingesetzten Monomeren ab. Die für die erfindungsgemäßen Klebemassen verwendeten Acrylatdispersionen weisen im getrockneten Zustand Glasübergangstemperaturen, insbesondere zwischen -80 °C und -15 °C, bevorzugt zwischen -75 °C und -25 °C und besonders bevorzugt zwischen -55 °C und -35 °C auf.

Der Feststoffgehalt der Acrylatdispersionen liegt insbesondere zwischen 30 und 70 Gew.-%, bevorzugt zwischen 45 und 60 Gew.-%.

Beispielhaft seien die Acrylatdispersionen Primal PS 83d, Primal PS 90 der Firma Rohm & Haas genannt.

Falls erwünscht, kann die Dispersion weitere Zusätze enthalten. Geeignete Vernetzungsmittel können Epoxydharze, Aminderivate wie beispielsweise Hexamethoxymethylmelamin und/oder Kondensationsprodukte von einem Amin, zum Beispiel Melamin oder Harnstoff mit einem Aldehyd, zum Beispiel Formaldehyd sein. Um nicht klebende Polyacrylatdispersionen zu erhalten, hat sich gezeigt, dass es günstig ist weitere Stoffe gegebenenfalls zuzugeben, die zum Beispiel mit den Carboxylgruppen des Polymers reagieren. Beispiele dafür sind Aziridine, wie Ethylenimin, Propylenimin.

Die Klebemassen können weitere Komponenten enthalten. Beispiele sind Harze, Weichmacher, Farbstoffe, Entschäumer und Verdickungsmittel sowie weitere Zuschlagstoffe zum Einstellen des gewünschten rheologischen Verhaltens. Modifikationen von Acrylatdispersionen sind bekannt und beispielsweise beschrieben in "Modification of Acrylic Dispersions", Alexander Zettl in Handbook of Pressure Sensitive Adhesive Technology, Second Edition edited by Donatas Satas, Van Nostrand Reinhold New York, Seiten 457 bis 493.

Wässrige Harzdispersionen, dass heißt Dispersionen von Harz in Wasser, sind bekannt. Herstellung und Eigenschaften sind beispielsweise beschrieben in "Resin Dispersions", Anne Z. Casey in Handbook of Pressure Sensitive Adhesive Technology, Second Edition, edited by Donatas Satas, Van Nostrand Reinhold New York, Seiten 545 bis 566.

Harzdispersionen von Kohlenwasserstoffharzen und modifizierten Kohlenwasserstoffharzen sind ebenfalls bekannt und werden beispielsweise von Firma Hercules BV unter dem Handelsnamen Tacolyn angeboten (Beispiel Tacolyn 4177).

Geeignet sind Harzdispersionen auf Basis von Kohlenwasserstoffharzen oder modifizierten Kohlenwasserstoffharzen mit einem Erweichungspunkt zwischen 50 °C und 100 °C. Die Klebemasse kann beispielsweise 5 bis 28 Gew.-% der Harzdispersionen enthalten. Der Feststoffgehalt der Harzdispersionen liegt üblicherweise zwischen 40 und 70 Gew.-%.

Der Klebemasse können Harzdispersionen auf Basis von Mischungen verschiedener Kohlenwasserstoffharze, sowie von Mischungen von Kohlenwasserstoffharzen mit anderen bekannten Harzen, zugegeben werden. Möglich sind beispielsweise Mischungen von Kohlenwasserstoffharzen mit geringen Mengen von Harzen auf Basis von Kolophonium oder modifiziertem Kolophonium oder Phenolharzen, anderen Naturharzen, Harzestern oder Harzsäuren.

Der Klebemasse können weiterhin weichmachende Komponenten wie Weichharze, Flüssigharze, Öle oder andere bekannte Komponenten wie beispielsweise alkoxylierte Alkylphenole zugegeben werden. Alkoxylierte Alkylphenole sind bekannt und beispielsweise beschrieben in US 4,277,387 A und EP 0 006 571 A. Die Verwendung von alkoxylierten Alkylphenolen als Weichmacher wurde unter anderem vorgeschlagen in "Modification of Acrylic Dispersions", Alexander Zettl in Handbook of Pressure Sensitive Adhesive Technology, Second Edition, edited by Donatas Satas, Van Nostrand Reinhold New York, Seite 471.

Die Eigenschaften der alkoxylierten Alkylphenole werden durch den Alkylrest und überwiegend durch den Aufbau der Polyglykoletherkette bestimmt. Bei der Herstellung kann sowohl Ethylenoxid als auch Propylenoxid verwendet werden. In einer besonderen Ausführung wird propoxyliertes Alkylphenol verwendet. Bevorzugt sind wasserunlösliche alkoxylierte Alkylphenole. Weiterhin bevorzugt sind alkoxylierte Alkylphenole mit einem Siedepunkt größer 100 °C, bevorzugt größer 130 °C und besonders bevorzugt größer 200 °C.

Die Klebemasse kann durch Einsatz von Vernetzern in Richtung auf höhere Scherfestigkeit optimiert werden. Auswahl und Anteil der Vernetzer ist dem Fachmann bekannt. Vernetzer für Acrylatdispersionen sind grundsätzlich bekannt und beispielsweise beschrieben in "Acrylic Adhesives", Donatas Satas in Handbook of Pressure Sensitive Adhesive Technology, Second Edition, edited by Donatas Satas, Van Nostrand Reinhold New York, Seiten 411 bis 419.

Vernetzer auf Basis von Isocyanat sind grundsätzlich geeignet, aber wegen der begrenzten Topfzeiten und des erhöhten Aufwands bezüglich Arbeitssicherheit nicht bevorzugt. Ein Beispiel für Vernetzer auf Basis von Isocyanat ist Basonat F DS 3425 X (BASF).

Bevorzugt sind isocyanatfreie Vernetzer, beispielsweise Vernetzer auf Basis von Salzen mehrfunktioneller Metalle. Diese sind grundsätzlich bekannt und werden beispielsweise in US 3,740,366 A, US 3,900,610 A, US 3,770,780 A und US 3,790,553 A beschrieben. Besonders geeignet sind Vernetzer auf Basis von Zinkkomplexen, die mit Carboxylgruppen kovalente und/oder komplexartige Bindungen ausbilden können.

Des Weiteren hat sich als Klebemasse eine solche auf Acrylathotmelt-Basis als geeignet erwiesen, die einen K-Wert von mindestens 20 aufweist, insbesondere größer 30, erhältlich durch Aufkonzentrieren einer Lösung einer solchen Masse zu einem als Hotmelt verarbeitbaren System.

Das Aufkonzentrieren kann in entsprechend ausgerüsteten Kesseln oder Extrudern stattfinden, insbesondere beim damit einhergehenden Entgasen ist ein Entgasungsextruder bevorzugt.

Eine derartige Klebemasse ist in der DE 43 13 008 A1 dargelegt, auf deren Inhalt hiermit Bezug genommen wird und deren Inhalt Teil dieser Offenbarung und Erfindung wird. Diesen auf diesem Wege hergestellten Acrylatmassen wird in einem Zwischenschritt das Lösungsmittel vollständig entzogen.

Zusätzlich werden dabei weitere leichtflüchtige Bestanteile entfernt. Nach der Beschichtung aus der Schmelze weisen diese Massen nur noch geringe Anteile an flüchtigen Bestandteilen auf. Somit können alle im oben angeführten Patent beanspruchten Monomere/Rezepturen übernommen werden. Ein weiterer Vorteil der beschriebenen Massen ist darin zu sehen, dass diese einen hohen K-Wert und damit ein hohes Molekulargewicht aufweisen. Dem Fachmann ist bekannt, dass sich Systeme mit höheren Molekulargewichten effizienter vernetzen lassen. Damit sinkt entsprechend der Anteil an flüchtigen Bestandteilen.

Die Lösung der Masse kann 5 bis 80 Gew.-%, insbesondere 30 bis 70 Gew.-% Lösungsmittel enthalten.

Vorzugsweise werden handelsübliche Lösungsmittel eingesetzt, insbesondere niedrig siedende Kohlenwasserstoffe, Ketone, Alkohole und/oder Ester.

Weiter vorzugsweise werden Einschnecken-, Zweischnecken- oder Mehrschneckenextruder mit einer oder insbesondere zwei oder mehreren Entgasungseinheiten eingesetzt. In der Klebemasse auf Acrylathotmelt-Basis können Benzoinderivate einpolymerisiert sein, so beispielsweise Benzoinacrylat oder Benzoinmethacrylat, Acrylsäure- oder Methacrylsäureester. Derartige Benzoinderivate sind in der EP 0 578 151 A1 beschrieben.

Die Klebemasse auf Acrylathotmelt-Basis kann aber auch chemisch vernetzt sein.

In einer besonders bevorzugten Ausführungsform werden als Selbstklebemassen Copolymerisate aus (Meth)acrylsäure und deren Estern mit 1 bis 25 C-Atomen, Malein-, Fumar- und/oder Itaconsäure und/oder deren Estern, substituierten (Meth)acrylamiden, Maleinsäureanhydrid und anderen Vinylverbindungen, wie Vinylestern, insbesondere Vinylacetat, Vinylalkoholen und/oder Vinylethern eingesetzt.

Der Restlösungsmittel-Gehalt sollte unter 1 Gew.-% betragen.

Für Anwendungsbereiche der verkapselten Bauteile mit besonders großer Temperaturbelastung eignen sich besonders Siliconkautschuke mit ihren herausragenden Eigenschaften. Sie weisen neben einer hohen UV- und Ozonbeständigkeit insbesondere die kombinierten Funktionen aus hoher Temperaturbeständigkeit, Elastizität und ausgeprägtem Dämpfungsverhalten gegenüber Schockeinflüssen und Vibrationen auf. Darüber hinaus haben Langzeittemperaturbelastungen im Bereich von -75 °C bis 260 °C keinen negativen Einfluss auf die Materialeigenschaften von Siliconkautschuken.

Als Siliconhaftklebemassen können besonders vorteilhaft sowohl die folgenden kondensationsvernetzenden Systeme bestehend aus Silikatharzen und Polydimethyl- oder Polydiphenylsiloxanen DC 280, DC 282, Q2-7735, DC 7358, Q2-7406 von Dow Corning, PSA 750, PSA 518, PSA 910 von GE Bayer Silicones, KRT 001, KRT 002, KRT 003 von ShinEtsu, PSA 45559 von Wacker Silicones sowie PSA 400 von Rhodia als auch vorteilhaft die folgenden additionsvernetzenden Systeme bestehend aus Silikatharzen, Polydimethyl- oder Polydiphenylsiloxanen und Crosslinkern (Vernetzersubstanzen, insbesondere funktionalisierte Hydrosilane) DC 7657, DC 2013 von Dow Corning, PSA 6574 von GE Bayer Silicones, KR 3700, KR 3701 von ShinEtsu eingesetzt werden.

Um den Polymerschicht(en) eine höhere Festigkeit zu verleihen, ist häufig auch die thermische Vernetzung nach dem Zusammenfügen aller für das Photovoltaik-Modul notwendigen Komponenten sinnvoll. Zur thermischen Vernetzung eignen sich besonders Peroxyde wie zum Beispiel Lupersol von Pennwalt Corp, Luccidol Division.

Die transparente Polymerschicht sowie die zweite Polymerschicht können als glatte oder gebürstete Blattware vorliegen. In einer alternativen Ausführungsform befinden sich beide Polymerschichten insbesondere in geringen Schichtdicken von 10 bis 500 μm auf einem Hilfsträger. Der Hilfsträger kann ein beidseitig antiadhäsiv beschichtetes Material sein, wie ein Trennpapier oder eine Trennfolie, auch Liner genannt, und wird nach dem Applizieren ausgedeckt. Er bildet keinen Bestandteil des resultierenden Laminats.

Vorzugsweise weist die zweite mit Schäumungsmittel gefüllte Polymerschicht nach dem Schäumen ein Raumgewicht von kleiner 900 kg/m$^3$, insbesondere von kleiner 700 kg/m$^3$ auf.

Gemäß der Erfindung handelt es sich bei dem Schäumungsmittel um Mikrokugeln, die aus einer Polymermembran bestehen, die ein Treibmittel umschließt, so genannte Mikroballons.

Der Anteil dieser Mikroballons in der zweiten Polymerschicht liegt weiter vorzugsweise zwischen 0,5 und 20 Gew.-%, weiter bevorzugt zwischen 2 und 12 Gew.-%.

Bei Mikroballons handelt es sich um elastische Hohlkugeln, die eine thermoplastische Polymerhülle aufweisen. Diese Kugeln sind mit niedrigsiedenden Flüssigkeiten oder verflüssigtem Gas gefüllt. Als Hüllenmaterial finden insbesondere Polyacrylnitril, PVDC, PVC oder Polyacrylate Verwendung. Als niedrigsiedende Flüssigkeit sind insbesondere Kohlenwasserstoffe der niederen Alkane, beispielsweise Isobutan oder Isopentan geeignet, die als verflüssigtes Gas unter Druck in der Polymerhülle eingeschlossen sind.

Durch ein Einwirken auf die Mikroballons, insbesondere durch eine Wärmeeinwirkung erweicht einerseits die äußere Polymerhülle. Gleichzeitig geht das in der Hülle befindliche flüssige Treibgas in seinen gasförmigen Zustand über. Dabei dehnen sich die Mikroballons irreversibel aus und expandieren dreidimensional. Die Expansion ist beendet, wenn sich der Innen- und der Außendruck ausgleichen. Da die polymere Hülle erhalten bleibt, erzielt man so einen geschlossenzelligen Schaum.

Es ist eine Vielzahl an Mikroballontypen kommerziell erhältlich wie zum Beispiel von der Firma Akzo Nobel die Expancel DU-Typen (dry unexpanded), welche sich im Wesentlichen über ihre Größe (6 bis 45 μm Durchmesser im unexpandierten Zustand) und ihre zur Expansion benötigten Starttemperatur (75 °C bis 220 °C) differenzieren. Wenn der Mikroballontyp beziehungsweise die Schäumungstemperatur auf das zur Massecompoundierung benötigte Temperaturprofil und die Maschinenparameter abgestimmt ist, können Massecompoundierung und Schäumung auch gleichzeitig in einem Schritt erfolgen.

Weiterhin sind unexpandierte Mikroballontypen auch als wässrige Dispersion mit einem Feststoff- beziehungsweise Mikroballonanteil von ca. 40 bis 45 Gew.-% erhältlich, weiterhin auch als polymergebundende Mikroballons (Masterbatche), zum Beispiel in Ethylenvinylacetat mit einer Mikroballonkonzentration von ca. 65 Gew.-%. Sowohl die Mikroballon-Dispersionen als auch die Masterbatche sind wie die DU-Typen zur Schäumung von Klebemassen entsprechend dem erfindungsgemäßen Verfahren geeignet.

Gemäß einer weiteren vorteilhaften Ausführungsform der Erfindung ist außen auf der freien Seite auf der ersten Polymerschicht und/oder außen auf der freien Seite auf der zweiten Polymerschicht zumindest eine zusätzliche Schicht angeordnet, welche vorzugsweise eine Wasserdampfdurchlässigkeit kleiner 200 g/m$^2$/24 h bei 37,8 °C, 90 % rel. Luftfeuchtigkeit und eine Sauerstoffdurchlässigkeit kleiner 20 cm$^3$/m$^2$/24 h bei 23 °C und 50 % rel. Luftfeuchtigkeit aufweist.

Diese Schichten bieten auf diese Weise einen weiteren Schutz für die verkapselten Bauteile.

Als transparente Schicht eignen sich Glas, insbesondere ein eisenarmes, gehärtetes Weißglas aber auch UV-stabile und witterungsstabile Polymerfolien mit einer geringen Wasserdampfdurchlässigkeit beziehungsweise Wasserdampfpermeation.

Unter Permeation versteht man den Vorgang, bei dem ein Stoff (Permeat) einen Festkörper durchdringt oder durchwandert. Die Triebkraft ist ein Konzentrationsgradient. Permeabilität wird durch Permeationsmessung geprüft.

Die Messung der Permeation erfolgt beispielsweise mit Spülgasmethode.

Folien und Membranen können danach sowohl mit beliebigen Gasen als auch mit Flüssigkeiten aller Art auf ihre Durchlässigkeit überprüft werden. Die Messtechniken für Gase beinhalten alle ein zentrales Modul, das von der zu testenden Membran geteilt wird: Auf der "Feed-Seite" wird die Messzelle mit dem Prüfgas überströmt, das übrige Retentat wird abgeleitet. Die auf der anderen Seite angekommene Menge des Gases (Permeat) wird vom Spülgas zu einem Detektor geführt, wo die Konzentration gemessen wird. Ober- und Unterteil der Zelle umschließen die zentrierte Membran. Ein O-Ring, der auf der Probe aufliegt, dichtet die Grenzfläche ab. Diese Art von Zellen ist meist aus Metall wie zum Beispiel Edelstahl gefertigt.

Für die gegebenenfalls nicht transparente Schicht auf der zweiten Polymerschicht eignen sich ebenso Glas oder UV-stabile und witterungsstabile Folien mit geringer Wasserdampfdurchlässigkeit, wie eine Tedlarfolie® von Dupont.

Ebenso geeignet sind Folien aus einem Folienteil, der von zumindest einer Kunststofffolie aus insbesondere Polyester gebildet wird, sowie einem auf dem Folienteil aufgebrachten metallischen Teil, der aus einer metallischen Schicht aus insbesondere Aluminium gebildet wird, wobei auf der auf der freiliegenden Seite der metallischen Schicht eine Klebemasse aufgebracht ist.

Die metallische Schicht dient dabei als Barriereschicht, hält also korrosionsfördernde Substanzen wie Wasser, Wasserdampf, Sauerstoff, Schwefeldioxid und Kohlendioxid vom zu schützenden Gut (insbesondere den flächenförmigen Funktionsschichten) fern.

In einer ersten vorteilhaften Ausführungsform der Erfindung weist die metallische Schicht eine Dicke von 10 nm bis 50 $\mu$m auf, insbesondere 12 bis 25 $\mu$m.

Das Aufbringen der metallischen Schicht auf den Folienteil geschieht beispielsweise durch Bedampfen, also indem ein Überzug auf der Kunststofffolie durch thermisches Verdampfen im Vakuum (elektrisch mit Elektronenstrahlen, durch Kathodenzerstäubung oder Drahtexplosion, gegebenenfalls mit Hilfe von Laser-Strahlen) erzeugt wird.

Als Kunststofffolie wird bevorzugt Polyester eingesetzt.

Daneben zeigen auch Folien aus zum Beispiel PUR, PP, PE, PVC, PVDC, PEN, PAN, EVOH und PA, PA mit Nanokomposits hervorragende Eigenschaften.

Bei PA mit Nanokomposits handelt es sich um ein mit Schichtsilicat gefülltes PA. Diese Teilchen haben eine plättchenförmige Struktur ähnlich wie Talkum. Im Gegensatz zu Talkum ist die Teilchengröße erheblich kleiner (Nanometerbereich). Diese Teilchen werden bei der Extrusion ausgerichtet und bilden eine Schichtstruktur. Die Teilchen selbst sind wie Glas völlig undurchlässig für Gase. Die Gase werden beim Durchdringen der Folie behindert, wodurch die verbesserte Barrierewirkung entsteht. Die Schichtstruktur bildet eine Art Labyrinth welches die Gase und Aromen passieren müssen. Aufgrund der geringen Teilchengröße sind die optischen Eigenschaften der Folie nicht beeinträchtigt.

Bevorzugt werden für die Kunststofffolie 10 $\mu$m bis 160 $\mu$m dicke Folien.

In einer weiteren vorteilhaften Ausgestaltung der Erfindung besteht der Folienteil aus einem Laminat aus Kunststofffolien, und zwar bevorzugt aus einer Polyesterfolie sowie aus einer Polyolefinfolie, wobei weiter bevorzugt die Polyolefinfolie mit der metallischen Schicht versehen ist.

Die Kunststofffolien werden mit Bindemitteln (Laminierharzen) wie Epoxid-, Melaminharzen, Thermoplasten usw. verklebt.

Bevorzugt werden 10 $\mu$m bis 40 $\mu$m dicke Polyesterfolien sowie 20 $\mu$m bis 120 $\mu$m dicke Polyolefinfolien.

Weiterhin können auch drei- oder mehrschichtige Laminate zum Einsatz kommen, ohne den Erfindungsgedanken zu verlassen.

Des Weiteren können auch symmetrische Laminataufbauten um einen AL- Folien Kern in besonderen Anwendungsfeldern von Vorteil sein.

Weiter ist vorteilhaft, wenn zwischen metallischer Schicht und Klebemasse ein zweiter Folienteil vorhanden ist.

Die beiden Folienteile bestehen in diesem Falle vorzugsweise aus identischen Kunststofffolien, weiter vorzugsweise ist der zweite Folienteil ebenfalls ein Laminat aus einer Polyesterfolie sowie aus einer Polyolefinfolie, wobei wieder insbesondere die Polyolefinfolie an der metallischen Schicht anliegt.

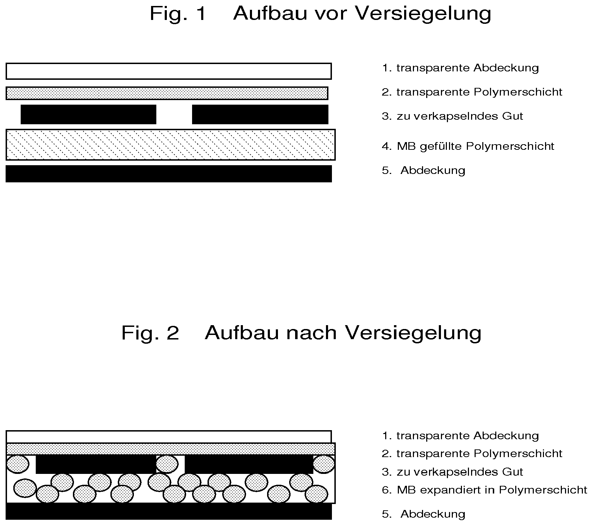

In der Figur 1 ist der Aufbau des Versiegelungssytems in einer vorteilhaften Ausführungsform gezeigt. Die zweite Polymerschicht 4, welche mit nicht aktiviertem Schäumungsmittel gefüllt ist, wobei es sich bei dem Schäumungsmittel handelt um nicht expandierte Mikroballons, befindet sich auf einer zusätzlichen Schicht in Form einer Abdeckung 5 (Kunststofffolie). Über der zweiten Polymerschicht 4 ist das zu verkapselnde Gut 3 (Solarzellen) angeordnet. Das Versiegelungssystem wird vervollständigt durch die erste transparente Polymerschicht 2, die sich wiederum auf einer zusätzlichen Schicht in Form einer transparenten Abdeckung 1 befindet. Die optisch aktive Seite der Solarzellen wird somit nur durch transparente Schichten abgedeckt.

Die Figur 2 zeigt das Versiegelungssystem, nachdem die Versiegelung stattgefunden hat. Die beiden Polymerschichten 2 und 6 sind miteinander verschweißt, die Mikroballons in der zweiten Polymerschicht 6 sind expandiert. Auf diese Weise umfließt diese Polymerschicht das zu verkapselnde Gut schnell und sicher gänzlich, so dass alle Lücken zwischen den Solarzellen ausgefüllt werden.

Die beiden Polymerschichten dienen zur Fixierung der optoelektronischen Bauteile und bilden zwei gegen Wasserdampf und Sauerstoff sperrende Substrate.

Die zu verkapselnden Bauteile werden zwischen einer ersten transparenten Polymerschicht und einer zweiten Polymerschicht eingebettet, und anschließend wird das Schäumungsmittel aktiviert, so dass die beiden Polymerschichten miteinander verschweißen und die Bauteile zwischen beiden Polymerschichten eingeschlossen sind..

Für den Fachmann nicht vorhersehbar war, dass die Verbindung zwischen der geschäumten und der ungeschäumten Polymerschicht derart stabil ist, dass eine sichere Verkapselung der Bauteile gewährleistet wird. Der Verkapselungsschritt ist so schnell, das es während der Verkapselung zu keiner Verschiebung des zu verkapselnden Guts kommt, ein Fixieren mittels eines Hilfsklebebandes ist nicht mehr nötig.

Darüber hinaus entfällt der Arbeitsschritt des Besäumens der Kanten nach dem Laminieren, da kaum Polymer über die Ränder austritt.

Mikroballon geschäumte Polymerschichten und (Selbst-)Klebemassen zeichnen sich durch eine definierte Zellstruktur mit einer gleichmäßigen Größenverteilung der Schaumzellen aus. Es sind geschlossenzellige Mikroschäume ohne Kavitäten, wodurch im Vergleich zu offenzelligen Varianten eine bessere Dichtung empfindlicher Güter gegen Staub und flüssige Medien erzielt werden kann.

Durch ihre flexible, thermoplastische Polymerschale besitzen derartige Schäume eine höhere Anpassungsfähigkeit als solche, die mit nicht expandierbaren, nicht polymeren Mikrohohlkugeln (Glashohlkugeln) gefüllt sind. Sie eignen sich besser zum Ausgleich von Fertigungstoleranzen, wie sie zum Beispiel bei Spritzgussteilen die Regel sind und können aufgrund ihres Schaumcharakters auch thermische Spannungen besser kompensieren.

Des Weiteren können durch die Auswahl des thermoplastischen Harzes der Polymerschale die mechanischen Eigenschaften des Schaums weiter beeinflusst werden. So ist es beispielsweise möglich, selbst dann, wenn der Schaum eine geringere Dichte als die Matrix aufweist, Schäume mit höherer Kohäsionsfestigkeit als mit der Polymermatrix allein herzustellen. So können typische Schaumeigenschaften wie die Anpassungsfähigkeit an raue Untergründe mit einer hohen Kohäsionsfestigkeit für PSA-Schäume kombiniert werden.

Klassisch chemisch oder physikalisch geschäumte Materialien sind demgegenüber für ein irreversibles Zusammenfallen unter Druck und Temperatur anfälliger. Auch die Kohäsionsfestigkeit ist hier niedriger.

Insofern bietet die bevorzugte Ausführungsform des Verfahrens erhebliche Vorteile, die dem Fachmann so nicht zuvor ableitbar waren.

Bei einer möglichen Ausführungsform des Verfahrens werden die in Figur 1 gezeigten Schichten übereinander angeordnet. Diese Anordnung wird unter einer Presse verpresst, bevorzugt bei 160 °C und/oder drucklos. Optional kann das Verpressen unter Vakuum erfolgen.

Unter der Presse wird das Schäumungsmittel zum Aufschäumen angeregt, so dass die beiden Polymerschichten miteinander verschweißen und die Bauteile zwischen beiden Polymerschichten eingeschlossen sind.

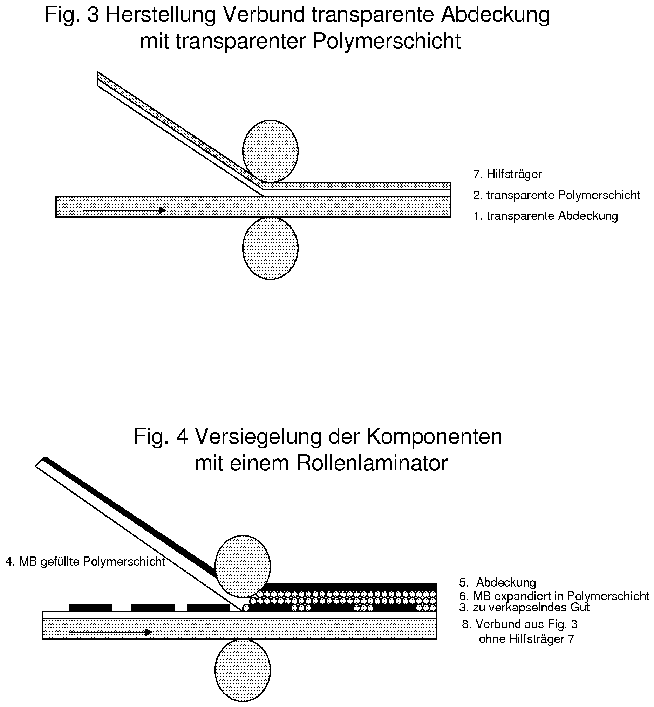

In den Figuren 3 bis 5 ist die Durchführung des erfindungsgemäßen Verfahrens unter Verwendung eines Rollenlaminators gezeigt.

Im ersten Schritt (Figur 3) wird auf eine transparente Abdeckung 1 die erste transparente Polymerschicht 2 aufgelegt, die sich ihrerseits auf einem Hilfsträger 7 befindet. Die Lamination erfolgt in einem Walzenspalt.

Das entstehende dreilagige Produkt kann aufgewickelt oder gelagert werden, es kann aber auch gleich der anschließenden Weiterverarbeitung zugeführt werden.

Der Hilfsträger 7 wird vor der Versiegelung entfernt, er wird nicht Teil des entstehenden Versiegelungssytems.

In der Figur 4 ist gezeigt, wie die erste transparente Polymerschicht 2 auf einer transparenten Abdeckung 1 (hergestellt gemäß Figur 3, nach Entfernung des Hilfsträgers 7), wobei auf der transparenten Polymerschicht 2, und zwar auf Seite, die der mit der transparenten Abdeckung 1 eingedeckten Seite gegenüberliegt, die zu verkapselnden Bauteile 3 angeordnet sind, und die zweite mit nicht aktiviertem Schäumungsmittel (Mikroballons) gefüllte Polymerschicht 4 auf einer weiteren Abdeckung 5 in einen Walzenspalt eines Rollenlaminators geführt werden. Die transparente Abdeckung 1 und die weitere Abdeckung 5 laufen direkt über die Walzen.

In dem Walzenspalt des Rollenlaminators erfolgt die Aufschäumung der Mikroballons, so dass die die beiden Polymerschichten 2 und 6 miteinander verschweißen und die Bauteile 3 zwischen beiden Polymerschichten 2 und 6 eingeschlossen sind.

Die Vorschubgeschwindigkeit, mit der die Schichten im Rollenlaminator verarbeitet werden, beträgt vorzugsweise 0,1 m/min bis 3 m/min, besonders bevorzugt 0,2 m/min bis 1 m/min. Die Temperatur der Walzen beträgt 160 °C, der Druck im Zylinder, mit dem die obere, bewegliche Walze auf die untere feststehende Walze gepresst wird, beträgt 2 bar. Bei den Walzen handelt es sich um Weichgummiwalzen.

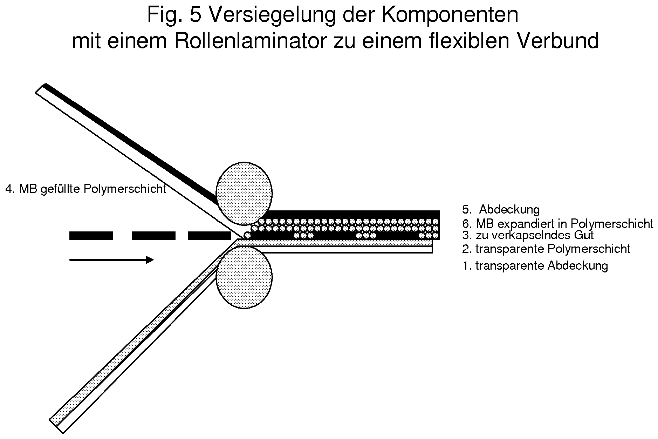

In der Figur 5 ist gezeigt, wie die erste transparente Polymerschicht 2 auf einer transparenten Abdeckung 1 (hergestellt gemäß Figur 3, nach Entfernung des Hilfsträgers 7), die zu verkapselnden Bauteile 3 und die zweite mit nicht aktiviertem Schäumungsmittel gefüllte Polymerschicht 4 auf einer weiteren Abdeckung 5 unabhängig in einen Walzenspalt eines Rollenlaminators geführt werden, wobei die transparente Abdeckung 1 und die weitere Abdeckung 5 direkt über die Walzen laufen und die zu verkapselnden Bauteile 3 zwischen die beiden Polymerschichten 2 und 4 geführt werden. In dem Walzenspalt des Rollenlaminators erfolgt die Aufschäumung der Mikroballons, so dass die die beiden Polymerschichten 2 und 6 miteinander verschweißen und die Bauteile 3 zwischen beiden Polymerschichten 2 und 6 eingeschlossen sind.

Die Vorschubgeschwindigkeit, mit der die Schichten im Rollenlaminator verarbeitet werden, beträgt vorzugsweise 0,1 m/min bis 3 m/min, besonders bevorzugt 0,2 m/min bis 1 m/min. Die Temperatur der Walzen beträgt 160 °C, der Druck im Zylinder, mit dem die obere, bewegliche Walze auf die untere feststehende Walze gepresst wird, beträgt 2 bar. Bei den Walzen handelt es sich um Weichgummiwalzen.

Im Folgenden wird die Erfindung anhand eines Beispieles näher erläutert, ohne dass dieses in irgendeiner Form einschränkend wirken sollen.

**Beispiele**

**Beispiel 1**

Polymerbasis Ethylenvinylacetat:

Ethylen-Vinylacetat-Kautschuk "Levamelt 456" (Lanxess) mit 45 Gew.-% Vinylacetatgehalt

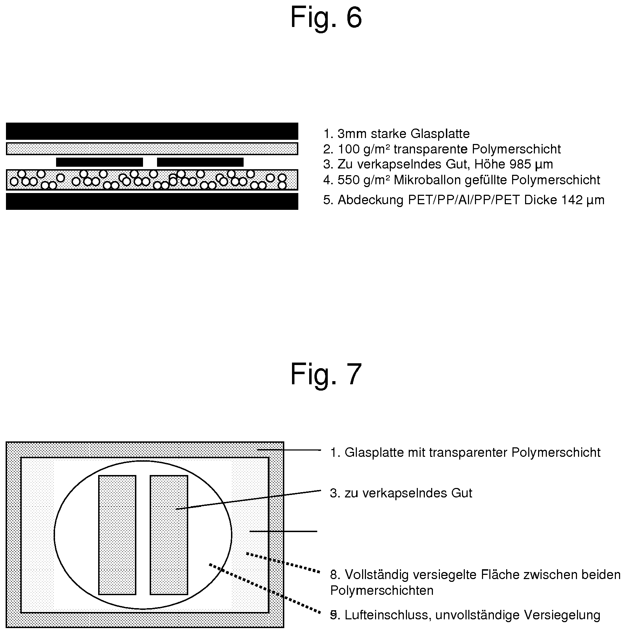

Versuchsdurchführung und Versuchsaufbau sind in der Figur 6 gezeigt.

Das Versiegelungssystem besteht aus folgenden Schichten:

- 3mm starke Glasplatte
- 100 g/m$^2$ erste transparente Polymerschicht
- zu verkapselndes Gut, Höhe 985 $\mu$m
- 550 g/m$^2$ zweite mit Mikroballons gefüllte Polymerschicht
- Abdeckung PET/PP/Al/PP/PET Dicke 142 $\mu$m

Die erste transparente Polymerschicht 2, bestehend aus Levamelt 456 mit 40 Gew.-% Feststoffgehalt in Toluol wird mit einer üblichen Rührvorrichtung im Labor hergestellt und anschließend mit einem Rakel auf einen antiadhäsiven Liner mit einem Masseauftrag von 100 g/m$^2$ beschichtet. Nachfolgend wird diese Polymerschicht 2 auf eine 3 mm starke Glasplatte 1 übertragen.

Das zu verkapselnde Gut 3 mit einer Höhe von 985 $\mu$m wird nun auf diese leicht haftende Polymerschicht 2 fixiert und die zweite mit Mikroballons gefüllte Polymerschicht 4 darüber laminiert.

Diese Mikroballon gefüllte Polymerschicht 4, bestehend aus 98 Gew.-% Levamelt 456 und 2 Gew.-% Expancel 051 DU 40 (Mikroballons der Firma Akzo Nobel) mit 40 Gew.-% Feststoffgehalt in Toluol, wird ebenfalls in einer Rührvorrichtung im Labor hergestellt und auf ein 5-Schichtlaminat aus Folien mit Abfolge PET/PP/Alu/PP/PET (Nordenia) mit einer Wasserdampfdurchlässigkeit kleiner 0,005 g/m$^2$/24 h bei 37,8 °C, 90% rel. Luftfeuchtigkeit und einer Sauerstoffdurchlässigkeit kleiner 0,005 cm$^3$/m$^2$/24 h bei 23 °C und 50 %, welches gleichzeitig als Abdeckung 5 dient, mit einem Masseauftrag von 550 g/m$^2$ ausgestrichen.

Das so präparierte Versuchsmuster wird nun mittels einer herkömmlichen Presse (Anpressdruck gegen 0 bar) aufgeheizt, um die Schäumung der Mikroballons zu initiieren und somit das zu verkapselnde Gut zu umschließen und zu versiegeln.

In Vorversuchen haben sich eine Verweildauer beziehungsweise Presszeit von 1,5 min und eine Temperatur von 160 °C als optimale Temperatur- beziehungsweise Schäumungsparameter erwiesen, das heißt, es wird die maximale Schäumungsrate und somit auch eine vollständige und sichere Versiegelung unter Luftblasenfreiheit erreicht (siehe Tabelle 1: Ermittlung der optimalen Schäumungs-/ Verkapselungsparameter).

Tabelle 1: Ermittlung der optimalen Schäumungs-/ Verkapselungsparameter

| Presszeit [s] | Versiegelungsrate [%] | | |
|---|---|---|---|
| | bei 140°C | 150 °C | 160 °C |
| 0 | 0 | 0 | 0 |
| 60 | 0 | 0 | 40 |
| 75 | 23 | 30 | 65 |
| 90 | 35 | 70 | 100 |
| 105 | 90 | 100 | ----- |
| 120 | 100 | ----- | ----- |

Die Versiegelungsrate gibt das Verhältnis der Gesamtfläche zum flächenmäßigen Anteil des Lufteinschlusses an, der sich bei noch nicht vollständiger Versiegelung um das zu verkapselnde Gut befindet. Das bedeutet, wenn die transparente Polymerschicht A noch nicht mit der Polymerschicht B verbunden ist, beträgt die Versiegelungsrate 0 % und umgekehrt.

Bei einer Temperatur von 160 °C stellt sich am schnellsten und stabilsten bereits nach 90s Presszeit ein Optimum ein.

Als Vergleich ist in der Figur 7 eine Versiegelungsrate von etwa 50 % dargestellt.

**Beispiel 2 - Vergleichsbeispiel**

Polymerbasis Ethylenvinylacetat:

Ethylen-Vinylacetat-Kautschuk "Levamelt 456" (Lanxess) mit 45 Gew.-% Vinylacetatgehalt

Dieses Vergleichsbeispiel dient dazu, um die Versiegelungsleistung einer ungefüllten beziehungsweise ungeschäumten Masse gegenüber einer mit Mikroballons geschäumten Masse gleicher Polymerbasis Levamelt 456 zu untersuchen und miteinander zu vergleichen.

Somit wird der Effekt der Mikroballon-Schäumung auf die Güte und Beschaffenheit der Verkapselung deutlich erkennbar und Vorteile gegenüber der Versiegelung mit ungeschäumten Massesystemen feststellbar.

Versuchsdurchführung und Versuchsaufbau sind analog zum Beispiel 1. Doch hier ist die zweite Polymerschicht nicht mit 2 Gew.-% Mikroballons, sondern mit 1 Gew.-% Titandioxid gefüllt, um eine bessere Sichtbarkeit des zu verkapselnden Guts gegenüber der transparenten Abdeckungen und der Versiegelungsrate zu gewährleisten.

Das so präparierte Versuchsmuster wird nun ebenfalls mittels einer herkömmlichen Presse (Anpressdruck gegen 0 bar) bei 160 °C aufgeheizt und nach mehreren regelmäßigen Zeitabständen die Vollständigkeit der Versiegelungsleistung kontrolliert. Eine optimale und komplette Verkapselung (siehe Tabelle 2) wurde erst nach 10 min bei 160 °C erreicht. Außerdem wurde eine zusätzliche unerwünschte Veränderung am Versuchsmuster festgestellt, welche nicht dem Erfindungsgedanken entspricht.

Bereits nach einer Presszeit von 5 min dehnt sich die ungeschäumte Polymermatrix dermaßen aus, dass diese die Anordnung und Lage des zu verkapselnden Guts auf der transparenten Polymerschicht A und im Gesamtsystem deformiert und verschiebt.

Es ist also mit einer ungeschäumten Polymerschicht keine sichere Versiegelung und gleichzeitige dauerhafte Positionierung des zu verkapselnden Guts möglich.

Tabelle 2: Versiegelungsrate des Referenzmusters

| Presszeit [min] | Versiegelungsrate [%] | |
|---|---|---|
| | 150 °C | 160 °C |
| 0 | 0 | 0 |
| 2 | 0 | 20 |
| 5 | 30 | 55 |
| 10 | 70 | 100 |
| 15 | 100 | 100 |

Dies zeigt sich in der Figur 7. Aufgrund der mangelhaften Fließeigenschaften der erwärmten zweiten Polymerschicht ist es nicht möglich, die Bauteile vollständig zu umgeben. Zwar versiegeln die beiden Polymerschichten im Randbereich vollständig (8), um die Bauteile herum kommt es hingegen zu Lufteinschlüssen und somit zu einer unvollständigen Versiegelung (9) (Versiegelungsrate von etwa 50 %).

Die erfindungsgemäße Versiegelung durch Schäumung von Mikroballon gefüllten Massesystemen verkürzt also die benötigte Dauer zur vollständigen Verkapselung, stellt folglich einen schonenden Versiegelungsprozess dar und wirkt sich ebenso positiv auf die Qualität aus.

**Patentansprüche**

1. Verfahren zur Verkapselung von optoelektronischen Bauteilen (3), wobei die zu verkapselnden Bauteile (3) zwischen einer ersten transparenten Polymerschicht (2) und einer zweiten Polymerschicht (4), welche mit nicht aktiviertem Schäumungsmittel gefüllt ist, eingebettet werden und anschließend das Schäumungsmittel aktiviert wird, so dass sich die beiden Polymerschichten (2, 4) miteinander verbinden und die Bauteile (3) zwischen beiden Polymerschichten (2, 4) eingeschlossen sind,
   **dadurch gekennzeichnet, dass** es sich bei dem Schäumungsmittel um Mikrokugeln, die aus einer Polymermembran bestehen, die ein Treibmittel umschließt, handelt.

2. Verfahren nach Anspruch 1,
   **dadurch gekennzeichnet, dass**
   sich die beiden Polymerschichten (2, 4) derart miteinander verbinden, dass sie miteinander verschweißen.

3. Verfahren nach Anspruch 1 oder 2,
**dadurch gekennzeichnet, dass**
außen auf der freien Seite auf der ersten Polymerschicht (2) und/oder außen auf der freien Seite auf der zweiten Polymerschicht (4) zumindest eine zusätzliche Schicht angeordnet ist, welche eine Wasserdampfdurchlässigkeit kleiner 200 g/m$^2$/24 h bei 37,8 °C, 90 % rel. Luftfeuchtigkeit und eine Sauerstoffdurchlässigkeit kleiner 20 cm$^3$/m$^2$/24 h bei 23 °C und 50 % rel. Luftfeuchtigkeit aufweist.

4. Verfahren nach zumindest einem der Ansprüche 1 bis 3,
**dadurch gekennzeichnet, dass**
die erste transparente Polymerschicht (2) eine Transmission von größer 90 % bei einer Wellenlänge von 350 bis 1150 nm aufweist.

5. Verfahren nach zumindest einem der vorherigen Ansprüche,
**dadurch gekennzeichnet, dass**
die erste transparente Polymerschicht (2) eine Schichtdicke von 50 bis 300 μm aufweist.

6. Verfahren nach zumindest einem der vorherigen Ansprüche,
**dadurch gekennzeichnet, dass**
die zweite mit Schäumungsmittel gefüllte Polymerschicht (4) nach dem Schäumen ein Raumgewicht von kleiner 700 kg/m$^3$ aufweist.

7. Verfahren nach zumindest einem der vorherigen Ansprüche,
**dadurch gekennzeichnet, dass**
die erste transparente Polymerschicht (2) und/oder die zweite Polymerschicht (4) auf einem antiadhäsiv ausgerüsteten Hilfsträger (7) vorliegen.

8. Verfahren nach zumindest einem der vorherigen Ansprüche,
**dadurch gekennzeichnet, dass**
als zusätzliche Schicht oberhalb der ersten Polymerschicht (2) eine transparente Schicht (1) aus Glas oder einem UV-stabilen und witterungsstabilen Kunststoff mit geringer Wasserdampfdurchlässigkeit gewählt wird und/oder als zusätzliche Schicht unterhalb der zweiten Polymerschicht (4) eine Schicht (5) aus Glas oder aus einer ein- oder mehrschichtigen UV-stabilen und witterungsstabilen Kunststofffolie mit geringer Wasserdampfdurchlässigkeit.

9. Verfahren nach zumindest einem der vorherigen Ansprüche,
**dadurch gekennzeichnet, dass**
die zweite Polymerschicht (4), welche mit nicht aktiviertem Schäumungsmittel gefüllt ist, sich auf einer zusätzlichen Schicht in Form einer Abdeckung (5) befindet, über der zweiten Polymerschicht (4) das zu verkapselnde Gut (3) angeordnet ist, darüber die erste transparente Polymerschicht (2) angeordnet ist, die sich wiederum auf einer zusätzlichen Schicht in Form einer transparenten Abdeckung (1) befindet,
wobei in dieser Anordnung unter Vakuum unter einer Presse das Schäumungsmittel zum Aufschäumen angeregt wird, so dass die beiden Polymerschichten (2, 4) miteinander verschweißen und die Bauteile (3) zwischen beiden Polymerschichten (2, 4) eingeschlossen sind.

10. Verfahren nach zumindest einem der vorherigen Ansprüche 1 - 8, **dadurch gekennzeichnet, dass**
die erste transparente Polymerschicht (2) auf einer transparenten Abdeckung (1), die zu verkapselnden Bauteile (3) und die zweite mit nicht aktiviertem Schäumungsmittel gefüllte Polymerschicht (4) auf einer weiteren Abdeckung (5) in einen Walzenspalt eines Rollenlaminators geführt werden, wobei die transparente Abdeckung (1) und die weitere Abdeckung (5) direkt über die Walzen laufen und die zu verkapselnden Bauteile (3) zwischen die beiden Polymerschichten (2, 4) geführt werden, wobei in dem Walzenspalt die Aufschäumung des Schäumungsmittels erfolgt, so dass die beiden Polymerschichten (2, 4) miteinander verschweißen und die Bauteile (3) zwischen beiden Polymerschichten (2, 4) eingeschlossen sind.

11. Verfahren nach zumindest einem der vorherigen Ansprüche 1 - 8, **dadurch gekennzeichnet, dass**
die erste transparente Polymerschicht (2) auf einer transparenten Abdeckung (1) angeordnet ist, wobei auf der transparenten Polymerschicht (2), und zwar auf der Seite, die der mit der transparenten Abdeckung (1) eingedeckten Seite gegenüberliegt, die zu verkapselnden Bauteile (3) angeordnet sind, und die zweite mit nicht aktiviertem Schäumungsmittel gefüllte Polymerschicht (4) auf einer weiteren Abdeckung (5) in einen Walzenspalt eines Rollenlaminators geführt werden, wobei die transparente Abdeckung (1) und die weitere Abdeckung (5) direkt über die Walzen laufen, wobei in dem Walzenspalt die Aufschäumung des Schäumungsmittels erfolgt, so dass die beiden Polymerschichten (2, 4) miteinander verschweißen und die Bauteile (3) zwischen beiden Polymerschichten (2, 4) eingeschlossen sind.

**Claims**

1. Method of encapsulating optoelectronic components (3), by embedding the components (3) to be encapsulated between a first transparent polymer layer (2) and a second polymer layer (4), which is filled with unactivated foaming agent, and then activating the foaming agent, so that the two polymer layers (2, 4) join to one another and the components (3) are enclosed between the two polymer layers **characterized in that** the foaming agent comprises microspheres which are composed of a polymer membrane which encloses a blowing agent.

2. Method according to Claim 1, **characterized in that** the two polymer layers (2, 4) join to one another in such a way that they weld to one another.

3. Method according to Claim 1 or 2, **characterized in that** externally on the free side on the first polymer layer (2) and/or externally on the free side on the second polymer layer (4) there is at least one additional layer which has a water vapour permeability of less than 200 g/m$^2$/24 h at 37.8°C, and 90% relative humidity and an oxygen permeability of less than 20 cm$^3$/m$^2$/24 h at 23°C and 50% relative humidity.

4. Method according to at least one of Claims 1 to 3, **characterized in that** the first transparent polymer layer (2) has a transmittance of greater than 90% for a wavelength of 350 to 1150 nm.

5. Method according to at least one of the preceding claims, **characterized in that** the first transparent polymer layer (2) has a thickness of 50 to 300 $\mu$m.

6. Method according to at least one of the preceding claims, **characterized in that** the second polymer layer (4), filled with foaming agent, has a density after foaming of less than 700 kg/m$^3$.

7. Method according to at least one of the preceding claims, **characterized in that** the first transparent polymer layer (2) and/or the second polymer layer (4) are present on an anti-adhesively treated auxiliary carrier (7).

8. Method according to at least one of the preceding claims, **characterized in that** a transparent layer (1) of glass or a UV-stable and weathering-stable plastic with low water vapour permeability is selected as an additional layer above the first polymer layer (2), and/or a layer (5) of glass or of a single-layer or multi-layer, UV-stable and weathering-stable polymeric film of low water vapour permeability is selected as an additional layer below the second polymer layer (4).

9. Method according to at least one of the preceding claims, **characterized in that** the second polymer layer (4), which is filled with unactivated foaming agent, is located on an additional layer in the form of a cover (5),
the product (3) to be encapsulated is disposed over the second polymer layer (4),
over it the first transparent polymer layer (2) is disposed, which is located in turn on an additional layer in the form of a transparent cover (1),
and in this arrangement, under reduced pressure in a press, the foaming agent is induced to foam, and so the two polymer layers (2, 4) weld to one another and the components (3) are enclosed between the two polymer layers (2, 4).

10. Method according to at least one of the preceding Claims 1-8, **characterized in that** the first transparent polymer layer (2) on a transparent cover (1), the components (3) to be encapsulated and the second polymer layer (4), filled with unactivated foaming agent, on a further cover (5), are guided into a roll nip of a roll laminator, the transparent cover (1) and the further cover (5) running directly over the rolls, and the components (3) to be encapsulated being guided between the two polymer layers (2, 4), the foaming of the foaming agent taking place in the roll nip, and so the two polymer layers (2, 4) weld to one another and the components (3) are enclosed between the two polymer layers (2, 4).

11. Method according to at least one of the preceding Claims 1-8, **characterized in that** the first transparent polymer layer (2) is disposed on a transparent cover (1), the components (3) to be encapsulated being disposed on the transparent polymer layer (2), and specifically on the side opposite the side covered by the transparent cover (1), and the second polymer layer (4), filled with unactivated foaming agent, on a further cover (5), are guided into a roll nip of a roll laminator, the transparent cover (1) and the further cover (5) running directly over the rolls, and the foaming of the foaming agent takes place in the roll nip, and so the two polymer layers (2, 4) weld to one another and the components (3) are enclosed between the two polymer layers (2, 4).

**Revendications**

1. Procédé d'encapsulation de composants optoélectroniques (3), selon lequel les composants à encapsuler (3) sont incorporés entre une première couche de polymère transparente (2) et une deuxième couche de polymère (4), qui est chargée avec un agent moussant non activé, puis l'agent moussant est activé, de telle sorte que les deux couches de polymère (2, 4) se relient l'une avec l'autre et que les composants (3) soient enfermés entre les deux couches de polymère (2, 4),
   **caractérisé en ce que**
   l'agent moussant consiste en des microbilles qui sont constituées par une membrane polymère qui entoure un agent gonflant.

2. Procédé selon la revendication 1, **caractérisé en ce que** les deux couches de polymère (2, 4) se relient l'une avec l'autre de telle sorte qu'elles soient soudées l'une avec l'autre.

3. Procédé selon la revendication 1 ou 2, **caractérisé en ce qu'**au moins une couche supplémentaire est agencée à l'extérieur sur le côté libre de la première couche de polymère (2) et/ou à l'extérieur sur le côté libre de la deuxième couche de polymère (4), qui présente une perméabilité à la vapeur d'eau inférieure à 200 g/m$^2$/24 h à 37,8 °C, 90 % d'humidité relative de l'air et une perméabilité à l'oxygène inférieure à 20 cm$^3$/m$^2$/24 h à 23 °C et 50 % d'humidité relative de l'air.

4. Procédé selon au moins l'une quelconque des revendications 1 à 3, **caractérisé en ce que** la première couche de polymère transparente (2) présente une transmission supérieure à 90 % à une longueur d'onde de 350 à 1 150 nm.

5. Procédé selon au moins l'une quelconque des revendications précédentes, **caractérisé en ce que** la première couche de polymère transparente (2) présente une épaisseur de couche de 50 à 300 $\mu$m.

6. Procédé selon au moins l'une quelconque des revendications précédentes, **caractérisé en ce que** la deuxième couche de polymère (4) remplie avec un agent moussant présente après le moussage un poids volumique inférieur à 700 kg/m$^3$.

7. Procédé selon au moins l'une quelconque des revendications précédentes, **caractérisé en ce que** la première couche de polymère transparente (2) et/ou la deuxième couche de polymère (4) se trouvent sur un support auxiliaire à traitement antiadhésif (7).

8. Procédé selon au moins l'une quelconque des revendications précédentes, **caractérisé en ce qu'**une couche transparente (1) en verre ou en un plastique stable aux UV et stable aux intempéries ayant une faible perméabilité à la vapeur d'eau est choisie en tant que couche supplémentaire au-dessus de la première couche de polymère (2) et/ou un couche (5) en verre ou en un film en matière plastique mono- ou multicouche stable aux UV et stable aux intempéries ayant une faible perméabilité à la vapeur d'eau en tant que couche supplémentaire en dessous de la deuxième couche de polymère (4).

9. Procédé selon au moins l'une quelconque des revendications précédentes, **caractérisé en ce que** la deuxième couche de polymère (4), qui est chargée avec un agent moussant non activé, se trouve sur une couche supplémentaire sous la forme d'un revêtement (5), le produit à encapsuler (3) est agencé au-dessus de la deuxième couche de polymère (4), la première couche de polymère transparente (2) est agencé au-dessus, qui se trouve elle-même sur une couche supplémentaire sous la forme d'un revêtement transparent (1), l'agent moussant étant amené à mousser dans cet agencement sous vide sous une presse, de telle sorte que les deux couches de polymère (2, 4) soient soudées l'une avec l'autre et que les composants (3) soient enfermés entre les deux couches de polymère (2, 4).

10. Procédé selon au moins l'une quelconque des revendications 1 à 8 précédentes, **caractérisé en ce que** la première couche de polymère transparente (2) sur un revêtement transparent (1), les composants à encapsuler (3) et la deuxième couche de polymère (4) chargée avec un agent moussant non activé sur un revêtement supplémentaire (5) sont acheminés dans une fente entre les cylindres d'un lamineur à cylindres, le revêtement transparent (1) et le revêtement supplémentaire (5) passant directement sur les cylindres et les composants à encapsuler (3) étant acheminés entre les deux couches de polymère (2, 4), le moussage de l'agent moussant ayant lieu dans la fente entre les cylindres, de telle sorte que les deux couches de polymère (2, 4) soient soudées l'une avec l'autre, et que les composants (3) soient enfermés entre les deux couches de polymère (2, 4).

**11.** Procédé selon au moins l'une quelconque des revendications 1 à 8 précédentes, **caractérisé en ce que** la première couche de polymère transparente (2) agencée sur un revêtement transparent (1), les composants à encapsuler (3) étant agencés sur la couche de polymère transparente (2), et ce sur le côté opposé au côté recouvert avec le revêtement transparent (1), et la deuxième couche de polymère (4) chargée avec un agent moussant non activé sur un revêtement supplémentaire (5) sont acheminées dans une fente entre les cylindres d'un lamineur à cylindres, le revêtement transparent (1) et le revêtement supplémentaire (5) passant directement sur les cylindres, le moussage de l'agent moussant ayant lieu dans la fente entre les cylindres, de telle sorte que les deux couches de polymère (2, 4) soient soudées l'une avec l'autre, et que les composants (3) soient enfermés entre les deux couches de polymère (2, 4).

Fig. 1   Aufbau vor Versiegelung

1. transparente Abdeckung

2. transparente Polymerschicht

3. zu verkapselndes Gut

4. MB gefüllte Polymerschicht

5.  Abdeckung

Fig. 2   Aufbau nach Versiegelung

1. transparente Abdeckung

2. transparente Polymerschicht

3. zu verkapselndes Gut

6. MB expandiert in Polymerschicht

5.  Abdeckung

## Fig. 3 Herstellung Verbund transparente Abdeckung mit transparenter Polymerschicht

7. Hilfsträger

2. transparente Polymerschicht

1. transparente Abdeckung

## Fig. 4 Versiegelung der Komponenten mit einem Rollenlaminator

4. MB gefüllte Polymerschicht

5. Abdeckung

6. MB expandiert in Polymerschicht

3. zu verkapselndes Gut

8. Verbund aus Fig. 3 ohne Hilfsträger 7

## Fig. 5 Versiegelung der Komponenten
## mit einem Rollenlaminator zu einem flexiblen Verbund

4. MB gefüllte Polymerschicht

5. Abdeckung
6. MB expandiert in Polymerschicht
3. zu verkapselndes Gut
2. transparente Polymerschicht
1. transparente Abdeckung

# Fig. 6

1. 3mm starke Glasplatte
2. 100 g/m² transparente Polymerschicht
3. Zu verkapselndes Gut, Höhe 985 μm
4. 550 g/m² Mikroballon gefüllte Polymerschicht
5. Abdeckung PET/PP/Al/PP/PET Dicke 142 μm

# Fig. 7

1. Glasplatte mit transparenter Polymerschicht

3. zu verkapselndes Gut

8. Vollständig versiegelte Fläche zwischen beiden Polymerschichten

9. Lufteinschluss, unvollständige Versiegelung

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9422172 A1
- JP 09312410 A
- EP 1302988 A1
- US 20020166687 A1
- JP 2002043598 A
- US 4277387 A
- EP 0006571 A
- US 3740366 A
- US 3900610 A
- US 3770780 A
- US 3790553 A
- DE 4313008 A1
- EP 0578151 A1

**In der Beschreibung aufgeführte Nicht-Patentliteratur**

- Ullmann's Enzyklopädie der technischen Chemie. vol. 12, 525-555
- Acrylic Adhesives. Donatas Satas in Handbook of Pressure Sensitive Adhesive Technology. Van Nostrand Reinhold, 396-456
- Modification of Acrylic Dispersions. **ALEXANDER ZETTL.** Handbook of Pressure Sensitive Adhesive Technology. Van Nostrand Reinhold, 457-493
- Resin Dispersions. **ANNE Z. CASEY.** Handbook of Pressure Sensitive Adhesive Technology. Van Nostrand Reinhold, 545-566
- Modification of Acrylic Dispersions. **ALEXANDER ZETTL.** Handbook of Pressure Sensitive Adhesive Technology. Van Nostrand Reinhold, 471
- Acrylic Adhesives. **DONATAS SATAS.** Handbook of Pressure Sensitive Adhesive Technology. Van Nostrand Reinhold, 411-419